# EUROPÄISCHE PATENTSCHRIFT

(11) **EP 1 803 163 B1**
(45) Veröffentlichungstag und Bekanntmachung des Hinweises auf die Patenterteilung: **26.03.2008**
(21) Anmeldenummer: 05788493.4
(22) Anmeldetag: 13.09.2005
(51) Int. Cl.: H01L 33/00

(54) **OPTOELEKTRONISCHES BAUELEMENT MIT EINER DRAHTLOSEN KONTAKTIERUNG**
OPTOELECTRONIC COMPONENT WITH A WIRELESS CONTACTING
COMPOSANT OPTOELECTRONIQUE POURVU D'UN CONTACT SANS FIL

(30) Priorität: 30.09.2004 DE 102004047680; 15.10.2004 DE 102004050371
(43) Veröffentlichungstag der Anmeldung: 04.07.2007
(60) Teilanmeldung: 08001217.2
(73) Patentinhaber: OSRAM Opto Semiconductors GmbH, 93055 Regensburg (DE)
(72) Erfinder: GUENTHER, Ewald Karl Michael, 93128 Regenstauf (DE); SORG, Jörg Erich, 93053 Regensburg (DE); STATH, Norbert, 93049 Regensburg (DE)
(74) Vertreter: Epping - Hermann - Fischer
(86) Internationale Anmeldenummer: PCT/DE2005/001603
(87) Internationale Veröffentlichungsnummer: WO 2006/034671

(56) Entgegenhaltungen:
- WO-A-02/065558
- US-A- 4 936 808
- US-A- 5 538 919
- US-A1- 2004 041 159
- MARGALITH T ET AL: "Indium tin oxide contacts to gallium nitride optoelectronic devices" APPLIED PHYSICS LETTERS, AIP, AMERICAN INSTITUTE OF PHYSICS, MELVILLE, NY, US, Bd. 74, Nr. 26, 28. Juni 1999 (1999-06-28), Seiten 3930-3932, XP012022993 ISSN: 0003-6951

## Beschreibung

Die Erfindung betrifft ein optoelektronisches Bauelement gemäß dem Oberbegriff des Patentanspruchs 1, ein Verfahren zur Herstellung eines optoelektronischen Bauelements nach dem Oberbegriff des Patentanspruchs 12 und eine Beleuchtungseinrichtung gemäß Patentanspruch 25.

Optoelektronische Bauelemente der genannten Art, wie zum Beispiel lichtemittierende Dioden (LEDs), weisen in der Regel zwei gegenüberliegende Kontaktflächen auf, wobei oftmals die erste Kontaktfläche auf einen elektrisch leitfähigen Träger, beispielsweise auf einen mit einer Metallisierungsschicht versehenen Bereich eines Chipgehäuses, montiert wird.

Die elektrische Kontaktierung der gegenüberliegenden zweiten Kontaktfläche eines Halbleiterchips gestaltet sich üblicherweise schwieriger, da diese in der Regel nicht an den vorgesehenen zweiten Anschlussbereich des Trägerkörpers angrenzt. Diese zweite Kontaktierung wird herkömmlicherweise mit einem Bonddraht hergestellt. Zur Herstellung einer elektrisch leitenden Verbindung zwischen dem Bonddraht und der zur kontaktierenden Chipoberfläche wird ein Bereich der Chipoberfläche mit einer metallischen Schicht, dem sogenannten Bondpad versehen. Diese Metallschicht hat aber den Nachteil, dass sie optisch nicht transparent ist und dadurch ein Teil des im Chip generierten Lichts absorbiert wird. Eine Reduzierung der Fläche des Bondpads ist jedoch technisch nur beschränkt möglich und erhöht den Herstellungsaufwand.

Um das Problem der Abschattung eines Teils der zur Strahlungsauskopplung vorgesehenen Oberfläche eines optoelektronischen Bauelements zu vermindern, ist aus der JP 09283801 A bekannt, eine auf der Oberfläche des Halbleiterchips angeordnete Elektrode mit einer elektrisch leitfähigen transparenten Schicht aus Indium-Zinn-Oxid (ITO) drahtlos zu kontaktieren. Die Seitenflanken des Halbleiterchips werden dabei durch eine isolierende Schicht aus SiO₂ von der leitfähigen transparenten Schicht elektrisch isoliert.

Aus der WO 98/12757 ist bekannt, einen optoelektronischen Halbleiterchip, der in herkömmlicher Weise mit einem Bonddraht kontaktiert ist, in eine Vergussmasse einzubetten, die Lumineszenz-Konversionsstoffe enthält, um zumindest einen Teil der von dem Halbleiterchip emittierten Strahlung zu größeren Wellenlängen hin zu konvertieren. Auf diese Weise kann zum Beispiel mit einem Halbleiterchip, der blaues oder ultraviolettes Licht emittiert, mischfarbiges oder weißes Licht erzeugt werden.

Patent Application Publication US 2004/0041159 A1 offenbart in den Figuren 4 - 7 ein optoelektronisches Bauelement das Licht in eine Hauptstrahlrichtung, senkrecht zu einem transparenten Film (5) emittiert. Das optoelektronische Bauelement verfügt über einen Halbleiterchip (2), der eine erste Hauptfläche, eine erste Kontaktfläche, und eine der ersten Hauptfläche gegenüberliegende zweite Hauptfläche mit einer zweiten Kontaktfläche aufweist. Desweiteren besitzt das optoelektronische Bauelement einen Trägerkörper (1) mit einem elektrischen Anschlussbereich. Der Halbleiterchip (2) ist mit der ersten Hauptfläche auf dem Trägerkörper (1) befestigt und die erste Kontaktfläche ist mit dem ersten Anschlussbereich elektrisch leitend verbunden. Der Halbleiterchip (2) und der Trägerkörper (1) können mit einer transparenten, elektrisch isolierenden Verkapselungsschicht (12) versehen werden. Die in der Hauptstrahlungsrichtung emittierte Strahlung wird dann durch die Verkapselungsschicht ausgekoppelt.

Der Erfindung liegt die Aufgabe zugrunde, ein verbessertes optoelektronisches Bauelement mit einer drahtlosen Kontaktierung anzugeben, bei dem der Halbleiterchip vor Umgebungseinflüssen geschützt ist, die mit Möglichkeit zur Wellenlängenkonversion der emittierten Strahlung besteht, und der Herstellungsaufwand vergleichsweise gering ist. Ferner soll ein vorteilhaftes Verfahren zur Herstellung eines derartigen optoelektronischen Bauelements angegeben werden.

Diese Aufgabe wird durch ein optoelektronisches Bauelement nach Patentanspruch 1 und ein Verfahren nach Patentanspruch 12 sowie durch eine Beleuchtungseinrichtung gemäß Anspruch 25 gelöst. Vorteilhafte Ausgestaltungen und Weiterbildungen der Erfindung sind Gegenstand der abhängigen Ansprüche.

Bei einem erfindungsgemäßen optoelektronischen Bauelement, das Strahlung in eine Hauptstrahlungsrichtung emittiert, mit einem Halbleiterchip, der eine erste Hauptfläche, eine erste Kontaktfläche, und eine der ersten Hauptfläche gegenüberliegende zweite Hauptfläche mit einer zweiten Kontaktfläche aufweist, sowie mit einem Trägerkörper, der zwei voneinander elektrisch isolierte Anschlussbereiche aufweist, wobei der Halbleiterchip mit der ersten Hauptfläche auf dem Trägerkörper befestigt ist und die erste Kontaktfläche mit dem ersten Anschlussbereich elektrisch leitend verbunden ist, sind der Halbleiterchip und der Trägerkörper mit einer transparenten, elektrisch isolierenden Verkapselungsschicht versehen. Dabei wird die in der Hauptstrahlungsrichtung emittierte Strahlung durch die Verkapselungsschicht ausgekoppelt. Weiterhin ist eine elektrisch leitfähige Schicht von der zweiten Kontaktfläche über einen Teilbereich der Verkapselungsschicht zu dem zweiten elektrischen Anschlussbereich des Trägerkörpers geführt, welche die zweite Kontaktfläche mit dem zweiten Anschlussbereich elektrisch leitend verbindet.

Die elektrisch isolierende Verkapselungsschicht erfüllt bei dem erfindungsgemäßen optoelektronischen Bauelement vorteilhaft mehrere Funktionen. Da die Verkapselungsschicht elektrisch isolierend ist, verhindert sie, dass durch die aufgebrachte elektrisch leitfähige Schicht ein Kurzschluss entsteht. Dies wäre zum Beispiel der Fall, wenn ein pn-Übergang des Halbeleiterchips durch das Aufbringen der elektrisch leitfähigen Schicht an der Seitenflanke des Halbleiterchips kurzgeschlossen würde oder die beiden Anschlussbereiche des Trägerkörpers durch die elektrisch leitfähige Schicht miteinander verbunden würden. Weiterhin schützt die Verkapselungsschicht den Halbleiterchip vor Umgebungseinflüssen, insbesondere vor Schmutz und Feuchtigkeit.

Da die von dem optoelektronischen Bauelement in der Hauptstrahlungsrichtung emittierte Strahlung durch die Verkapselungsschicht ausgekoppelt wird, kann die Verkapselungsschicht vorteilhaft auch ein Lumineszenz-Konversionsmaterial enthalten, um beispielsweise mit einem ultraviolette oder blaue Strahlung emittierenden Halbleiterchip Weißlicht zu erzeugen. Geeignete Lumineszenz-Konversionsmaterialien, wie zum Beispiel YAG:Ce (Y₃Al₅O₁₂:Ce³⁺), sind aus der WO 98/12757 bekannt, deren Inhalt hiermit durch Referenz aufgenommen wird. Im Hinblick auf die Effizienz der Lumineszenzkonversion ist es besonders vorteilhaft, wenn die Verkapselungsschicht unmittelbar an die zur Strahlungsauskopplung vorgesehene Oberfläche des Halbleiterchips angrenzt.

Bevorzugt enthält das optoelektronische Bauelement einen strahlungsemittierenden Halbleiterchip aus einem III-V-Verbindungshalbleitermaterial, insbesondere aus einem Nitridverbindungshalbleitermaterial.

Die Verkapselungsschicht ist beispielsweise eine Kunststoffschicht. Bevorzugt ist sie eine Silikonschicht, da sich Silikon durch eine hohe Strahlungsbeständigkeit, insbesondere gegenüber UV-Licht, auszeichnet.

Besonders bevorzugt ist die Verkapselungsschicht eine Glasschicht. Eine Verkapselungsschicht aus einem Glas hat den Vorteil, dass ein Glas einen thermischen Ausdehnungskoeffizienten aufweist, der in der Regel besser an den Halbleiterchip angepasst ist als bei einem Kunststoff. Dadurch werden temperaturbedingte mechanische Spannungen, die zu Rissen in der Verkapselungsschicht oder sogar zu einem Ablösen der Verkapselungsschicht führen könnten, vorteilhaft vermindert. Ebenfalls wird ein durch Temperaturspannungen bedingtes Ablösen der elektrisch leitfähigen Schicht von der Verkapselungsschicht vermieden. Weiterhin zeichnet sich ein Glas durch eine im Vergleich zu einem Kunststoff geringere Aufnahme von Feuchtigkeit aus. Ferner ist auch die Beständigkeit gegen ultraviolette Strahlung bei einer Verkapselungsschicht aus einem Glas sehr hoch.

Die erste Hauptfläche des Halbleiterchips kann gleichzeitig die erste Kontaktfläche sein, und der Halbleiterchip an dieser Kontaktfläche auf dem ersten Anschlussbereich des Trägerkörpers befestigt sein. Beispielsweise kann die erste Kontaktfläche des Halbleiterchips die Rückseite eines Substrats sein, die bevorzugt mit einer Metallisierung versehen ist, und die elektrische Verbindung zum ersten Anschlussbereich des Trägerkörpers mit einer Lötverbindung oder einem elektrisch leitfähigen Klebstoff erfolgen.

Alternativ ist es aber auch möglich, dass sich sowohl die erste als auch die zweite Kontaktfläche auf der zweiten Hauptfläche des Halbleiterchips befinden und beide Kontaktflächen mit voneinander isolierten elektrisch leitfähigen Schichten mit jeweils einem der beiden Anschlussbereiche des Trägerkörpers verbunden sind. Dies ist vorteilhaft bei Halbleiterchips, die ein isolierendes Substrat enthalten, zum Beispiel ein Saphirsubstrat. Isolierende Saphirsubstrate werden zum Beispiel oftmals bei Halbleiterchips auf der Basis von Nitridverbindungshalbleitern verwendet.

Die elektrisch leitfähige Schicht ist beispielsweise eine strukturierte Metallschicht. Diese Metallschicht ist vorzugsweise derart strukturiert, dass sie nur einen geringen Teil der zweiten Hauptfläche des Halbleiterchips bedeckt, um eine Absorption der von dem optoelektronischen Bauelement emittierten Strahlung in der Metallschicht zu vermindern. Die Strukturierung der Metallschicht kann zum Beispiel mittels Photolithographie erfolgen.

Besonders bevorzugt ist die elektrisch leitfähige Schicht eine für die emittierte Strahlung transparente Schicht. Dies ist insbesondere zur Verminderung des Herstellungsaufwands vorteilhaft, da die transparente Schicht nicht von den zur Strahlungsauskopplung vorgesehenen Bereichen der isolierenden Schicht entfernt werden muss, und somit keine Strukturierung notwendig ist. Die elektrisch leitfähige Schicht kann beispielsweise ein transparentes leitfähiges Oxid (TCO) enthalten, insbesondere Indium-Zinn-Oxid (ITO).

Wenn eine potentialfreie Oberfläche des optoeLektronischen Bauelements erwünscht ist, ist vorteilhaft eine isolierende Deckschicht, beispielsweise eine Lackschicht, auf die elektrisch leitfähige Schicht aufgebracht.

Bei einem erfindungsgemäßen Verfahren zur Herstellung eines optoelektronischen Bauelements, das Strahlung in eine Hauptstrahlungsrichtung emittiert, mit einem Halbleiterchip, der eine erste Hauptfläche, eine erste Kontaktfläche und eine der ersten Hauptfläche gegenüberliegende zweite Hauptfläche mit einer zweiten Kontaktfläche aufweist, sowie mit einem Trägerkörper, der zwei elektrisch voneinander isolierte Anschlussbereiche aufweist, wird der Halbleiterchip mit der ersten Hauptfläche auf den Trägerkörper montiert, nachfolgend eine transparente isolierende Verkapselungsschicht auf den Halbleiterchip und den Trägerkörper aufgebracht, eine erste Ausnehmung in der Verkapselungsschicht zur zumindest teilweisen Freilegung der zweiten Kontaktfläche des Halbleiterchips und eine zweite Ausnehmung in der Verkapselungsschicht zur zumindest teilweisen Freilegung des zweiten Anschlussbereichs des Trägerkörpers erzeugt. Nachfolgend wird eine elektrisch leitfähige Schicht zur Herstellung einer elektrisch leitfähigen Verbindung zwischen der zweiten Kontaktfläche des Halbleiterchips und dem zweiten Anschlussbereich des Trägerkörpers aufgebracht.

Die Verkapselungsschicht ist vorzugsweise eine Kunststoffschicht. Diese kann beispielsweise durch Auflaminieren einer Kunststofffolie, durch Aufdrucken oder Aufsprühen einer Polymerlösung aufgebracht werden.

Bei einer besonders bevorzugten Variante des erfindungsgemäßen Verfahrens wird zunächst eine Precursor-Schicht auf den Halbleiterchip und den Trägerkörper aufgebracht, beispielsweise mittels eines Sol-Gel-Verfahrens, durch Aufdampfen oder durch Aufschleudern (Spincoating) einer Suspension. Durch eine erste Temperaturbehandlung werden die organischen Bestandteile der Precursor-Schicht nachfolgend entfernt. Die so entstandene Schicht wird nachfolgend mit einer zweiten Temperaturbehandlung verdichtet, um eine Verkapselungsschicht in Form einer Glasschicht zu erzeugen.

Die erste und zweite Ausnehmung in der Verkapselungsschicht werden vorzugsweise dadurch hergestellt, dass die Verkapselungsschicht in diesen Bereichen mittels einer Laserbestrahlung abgetragen wird.

Die elektrisch leitfähige Schicht wird vorteilhaft mit einem PVD-Verfahren, beispielsweise mittels Sputtern, aufgebracht und nachfolgend mittels galvanischer Abscheidung verstärkt.

Alternativ kann die elektrisch leitfähige Schicht auch mit einem Druckverfahren, insbesondere mit einem Siebdruckverfahren, aufgebracht werden. Ferner kann die elektrisch leitfähige Schicht auch mit einem Aufsprüh- oder Aufschleuderverfahren (Spincoating) erzeugt werden.

Ein erfindungsgemäßes optoelektronisches Bauelement ist besonders vorteilhaft für die Verwendung in Beleuchtungseinrichtungen, insbesondere in Hochleistungs-Beleuchtungseinrichtungen wie beispielsweise Scheinwerfern, geeignet. Dabei weist das optoelektronische Bauelement oder die Beleuchtungseinrichtung gemäß einer zweckmäßigen Ausführungsform eine Vielzahl von Halbleiterchips auf. Insbesondere kann das optoelektronische Bauelement in einem Frontscheinwerfer eines Kraftfahrzeugs oder als Lichtquelle in Projektionsapplikationen, beispielsweise in Bild- und/oder Video-Projektoren, eingesetzt werden.

Die Beleuchtungseinrichtung weist mit Vorteil mindestens ein optisches Element auf. Bevorzugt ist jedem Halbleiterchip des optoelektronischen Bauelements mindestens ein optisches Element zugeordnet. Das optische Element dient zur Ausbildung eines Strahlenkegels mit einer möglichst hohen Strahlenintensität und einer möglichst geringen Divergenz.

Bevorzugt ist mehreren Halbleiterchips gemeinsam ein optisches Element zugeordnet. Dies hat beispielsweise den Vorteil einer vereinfachten Montage, verglichen mit dem Fall, dass jedem Halbleiterchip ein eigenes optisches Element zugeordnet ist. Zusätzlich oder alternativ sind die Halbleiterchips in mindestens zwei Gruppen unterteilt, denen jeweils ein eigenes optisches Element zugeordnet ist. Selbstverständlich ist es auch möglich, jedem Halbleiterchip ein eigenes optisches Element zuzuordnen. Es ist auch möglich, dass das Bauelement oder die Beleuchtungseinrichtung einen einzigen Halbleiterchip aufweist, dem ein einziges optisches Element zugeordnet ist.

Das optische Element ist bevorzugt in der Art eines nichtabbildenden optischen Konzentrators ausgebildet, der, verglichen mit einer üblichen Verwendung eines Konzentrators, für eine Durchstrahlung in umgekehrter Richtung vorgesehen ist. Durch die Verwendung mindestens eines derartigen optischen Elementes kann die Divergenz des von der Lichtquelle emittierten Lichts mit Vorteil auf effiziente Weise verringert werden.

Hierbei ist es besonders vorteilhaft, wenn ein Lichteingang des optischen Konzentrators möglichst nahe an den Halbleiterchips positioniert ist, was mit der angegebenen drahtlosen Kontaktierung mit Vorteil besonders gut möglich ist, da diese, verglichen mit einer Kontaktierung mittels eines Bonddrahtes, mit einer besonders geringen Höhe ausgebildet werden kann. Zweckmäßigerweise wird der Raumwinkel, in dem das Licht aus dem optischen Element emittiert wird, mittels des optischen Elementes möglichst nah an den Halbleiterchips verkleinert, wo eine Querschnittsfläche des Strahlenkegels noch klein ist. Dies ist insbesondere dann erforderlich, wenn eine möglichst hohe Strahlungsstärke auf eine möglichst kleine Fläche projiziert werden soll, wie das bei Scheinwerferapplikationen oder Projektionseinrichtungen der Fall ist.

Eine wichtige Erhaltungsgröße in der geometrischen Optik ist dabei das Etendue, das heißt der Lichtleitwert. Sie ist das Produkt aus dem Flächeninhalt einer Lichtquelle und dem Raumwinkel, in den sie abstrahlt. Das Etendue beschreibt die Ausdehnung eines Lichtkegels beliebiger Intensität. Die Erhaltung des Etendue hat unter anderem zur Konsequenz, dass man das Licht einer diffusen Strahlungsquelle, zum Beispiel eines Halbleiterchips, nicht mehr konzentrieren, das heißt nicht mehr auf eine Fläche mit kleinerer Ausdehnung umlenken kann, ohne Verluste in Kauf zu nehmen, weshalb es vorteilhaft ist, wenn das Lichtbündel mit einem möglichst kleinen Querschnitt in das optische Element eintritt. Eben dies wird durch die angegebene Kontaktierung auf besonders vorteilhafte Weise ermöglicht.

In einer besonders zweckmäßigen Ausführungsform wird das Licht mittels des optischen Elementes derart stark kollimiert, das heißt die Divergenz des Lichtes wird derart stark verringert, dass es aus dem optischen Element in einem Strahlenkegel mit einem Öffnungswinkel emittiert wird, der kleiner als oder gleich 25°, bevorzugt kleiner als oder gleich 20°, besonders bevorzugt kleiner als oder gleich 15° ist.

Der optische Konzentrator ist mit Vorteil ein CPC-, CEC- oder CHC-artiger optischer Konzentrator, womit hierbei sowie im Folgenden ein Konzentrator gemeint ist, dessen reflektierende Seitenwände zumindest teilweise und/oder zumindest weitestgehend die Form eines zusammengesetzten parabolischen Konzentrators (Compound Parabolic Concentrator, CPC), eines zusammengesetzten elliptischen Konzentrators (Compound Elliptic Concentrator, CEC) und/oder eines zusammengesetzten hyperbolischen Konzentrators (Compound Hyperbolic Concentrator, CHC) aufweist.

Mit besonderem Vorteil sind die reflektierenden Flächen des optischen Elements teilweise oder vollständig als Freiformflächen ausgebildet, um eine gewünschte Abstrahlcharakteristik optimal einzustellen. In seiner Grundform ähnelt das optische Element dabei bevorzugt einem CPC, einem CEC oder einem CHC.

Alternativ weist der Konzentrator mit Vorteil Seitenwände auf, die einen Strahlungseingang mit einem Strahlungsausgang verbinden und die derart ausgebildet sind, dass auf den Seitenwänden verlaufende direkte Verbindungslinien zwischen dem Strahlungseingang und dem Strahlungsausgang im wesentlichen gerade verlaufen.

Das optische Element ist mit Vorteil in der Art eines dielektrischen Konzentrators ausgebildet und weist einen Grundkörper in Form eines Vollkörpers mit einem dielektrischen Material von geeignetem Brechungsindex auf, so dass in das optische Element eingekoppeltes Licht durch Totalreflektion an seitlichen Grenzflächen des Vollkörpers zum umgebenden Medium reflektiert wird. Durch die Ausnutzung der Totalreflektion kann eine Absorption des Lichts bei dessen Reflektion weitestgehend vermieden werden.

Mit Vorteil weist das optische Element einen Strahlungsausgang mit einer linsenartig gewölbten Grenzfläche auf. Dadurch lässt sich eine weitergehende Verringerung der Divergenz des Lichts erzielen.

Zweckmäßigerweise ist ein Teil benachbarter Halbleiterchips oder sind alle benachbarten Halbleiter mit einem möglichst geringen Abstand zueinander angeordnet. Der Abstand beträgt bevorzugt weniger als oder gleich 300 µm, besonders bevorzugt weniger als oder gleich 100 µm und ist größer als oder gleich 0 µm. Diese Maßnahme ist für das Erzielen einer möglichst hohen Strahldichte in von Vorteil. Gleichzeitig kann bei derart dicht angeordneten Halbleiterchips deren elektrische Kontaktierung mittels Bonddrähten unvorteilhaft sein, wogegen die angegebene drahtlose Kontaktierung für die elektrische Kontaktierung eng zueinander angeordneter Chips besonders vorteilhaft ist.

Die Erfindung wird im folgenden anhand von Ausführungsbeispielen in Zusammenhang mit den Figuren 1 bis 8 näher erläutert.

Es zeigen:
Figur 1 eine schematische Darstellung eines Querschnitts durch ein erstes Ausführungsbeispiel eines optoelektronischen Bauelements gemäß der Erfindung,
Figur 2 eine schematische Darstellung eines ersten Ausführungsbeispiels eines erfindungsgemäßen Verfahrens anhand von Zwischenschritten,
Figur 3 eine schematische Darstellung einer Variante des Aufbringens der Verkapselungsschicht und/oder der Deckschicht bei einem zweiten Ausführungsbeispiel eines erfindungsgemäßen Verfahrens,
Figur 4 eine schematische perspektivische Darstellung eines ersten Ausführungsbeispiels der Beleuchtungseinrichtung,
Figur 5 eine schematische perspektivische Darstellung eines zweiten Ausführungsbeispiels der Beleuchtungseinrichtung,
Figur 6 eine schematische perspektivische Darstellung eines dritten Ausführungsbeispiels der Beleuchtungseinrichtung,
Figur 7 eine schematische Schnittansicht eines Teils eines vierten Ausführungsbeispiels der Beleuchtungseinrichtung, und
Figur 8 eine schematische Schnittansicht eines Teils eines fünften Ausführungsbeispiels der Beleuchtungseinrichtung.

Gleiche oder gleichwirkende Elemente sind in den Figuren mit den gleichen Bezugszeichen versehen.

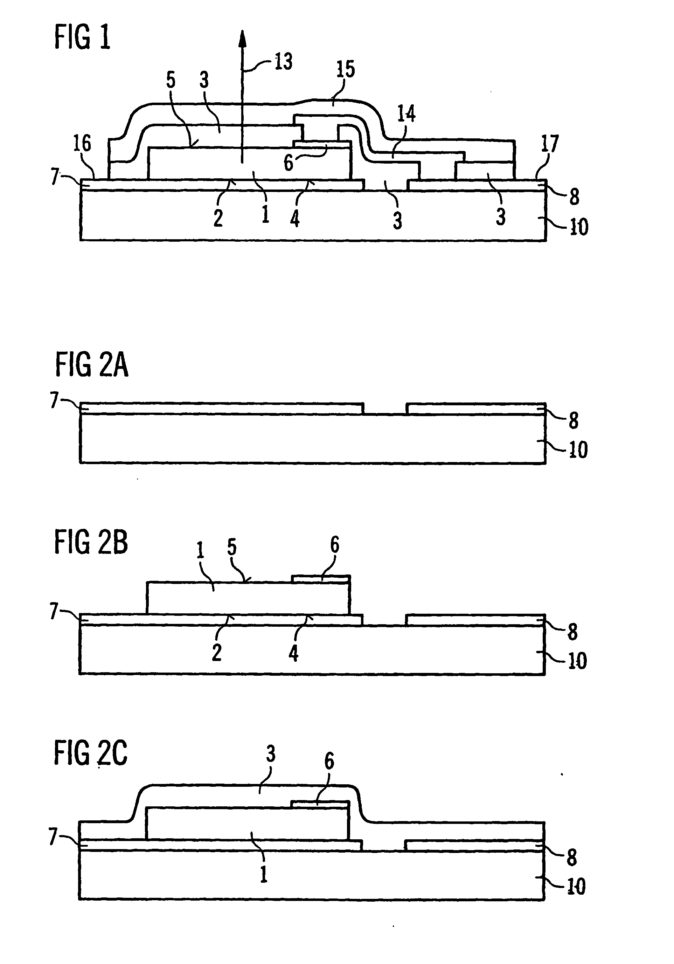

Das in Figur 1 dargestellte erste Ausführungsbeispiel eines optoelektronischen Bauelements gemäß der Erfindung enthält einen Trägerkörper 10, auf den zwei Kontaktmetallisierungen aufgebracht sind, die einen ersten Anschlussbereich 7 und einen zweiten Anschlussbereich 8 ausbilden. Ein Halbleiterchip 1 ist mit einer ersten Hauptfläche 2, die bei diesem Ausführungsbeispiel gleichzeitig die erste Kontaktfläche 4 darstellt, auf den ersten Anschlussbereich 7 montiert. Die Montage des Halbleiterchips 1 auf den ersten Anschlussbereich 7 erfolgt zum Beispiel durch Löten oder Kleben. An einer zweiten Hauptfläche 5 des Halbleiterchips 1, die der ersten Hauptfläche 2 gegenüberliegt, weist der Halbleiterchip 1 eine zweite Kontaktfläche 6 auf.

Der Halbleiterchip 1 und der Trägerkörper 10 sind mit einer Verkapselungsschicht 3 versehen. Die Verkapselungsschicht 3 ist vorzugsweise eine Kunststoffschicht. Insbesondere kann es sich um eine Silikonschicht handeln, da sich eine Silikonschicht durch eine besonders gute Strahlungsbeständigkeit auszeichnet. Besonders bevorzugt ist die Verkapselungsschicht 3 eine Glasschicht.

Die zweite Kontaktfläche 6 und der zweite Anschlussbereich 8 sind durch eine elektrisch leitfähige Schicht 14, die über einen Teilbereich der Verkapselungsschicht 3 geführt ist, miteinander verbunden. Die elektrisch leitfähige Schicht 14 enthält zum Beispiel ein Metall oder ein elektrisch leitfähiges transparentes Oxid (TCO), beispielsweise Indium-Zinn-Oxid (ITO), ZnO:Al oder SnO:Sb.

Um eine potentialfreie Oberfläche zu erhalten, ist auf die elektrisch leitfähige Schicht 14 vorteilhaft eine isolierende Deckschicht 15, beispielsweise eine Lackschicht aufgebracht. Im Fall einer transparenten isolierenden Deckschicht 15 muss diese vorteilhaft nicht strukturiert werden und kann daher ganzflächig auf das optoelektronische Bauelement aufgebracht sein. Vorteilhaft sind Teilbereiche 16, 17 der Anschlussflächen 7, 8 von der Verkapselungsschicht 3 und der Deckschicht 15 freigelegt, so dass in diesen freigelegten Teilbereichen 16, 17 elektrische Anschlüsse zur Stromversorgung des optoelektronischen Bauelements angebracht werden können.

Durch die Verkapselungsschicht 3 wird der Halbleiterchip 1 vor Umgebungseinflüssen, insbesondere vor Schmutz oder Feuchtigkeit, geschützt. Die Verkapselungsschicht 3 fungiert weiterhin als isolierender Träger der elektrisch leitfähigen Schicht 14, der einen Kurzschluss der Seitenflanke des Halbleiterchips 1 und/oder der beiden Anschlussflächen 7 oder 8 des Trägerkörpers verhindert.

Außerdem wird auch die von dem Halbleiterchip 1 in eine Hauptstrahlungsrichtung 13 emittierte Strahlung durch die Verkapselungsschicht 3 aus dem optoelektronischen Bauelement ausgekoppelt. Dies hat den Vorteil, dass der Verkapselungsschicht 3 ein Lumineszenz-Konversionsmaterial zugesetzt sein kann, mit dem die Wellenlänge von zumindest einem Teil der emittierten Strahlung zu größeren Wellenlängen hin verschoben wird. Insbesondere kann auf diese Weise Weißlicht erzeugt werden, in dem die von einem im blauen oder ultravioletten Spektralbereich emittierenden Halbleiterchip 1 erzeugte Strahlung teilweise in den komplementären gelben Spektralbereich konvertiert wird. Dazu wird bevorzugt ein Halbleiterchip 1 mit einer strahlungserzeugenden aktiven Zone, die ein Nitridverbindungshalbleitermaterial wie zum Beispiel GaN, AlGaN, InGaN oder InGaAlN enthält, verwendet.

Ein Ausführungsbeispiel eines erfindungsgemäßen Verfahrens wird im folgenden anhand der Figuren 2A bis 2F anhand von schematisch dargestellten Zwischenschritten näher erläutert.

Figur 2A zeigt einen Trägerkörper 10, auf dem zwei voneinander elektrisch isolierte Anschlussbereiche 7, 8 ausgebildet sind, zum Beispiel durch Aufbringen und Strukturieren einer Metallisierungsschicht.

Bei dem in Figur 2B dargestellten Zwischenschritt wird ein Halbleiterchip 1, der eine erste Hauptfläche 2 und eine zweite Hauptfläche 5 aufweist, mit einer ersten Kontaktfläche 4, die bei diesem Ausführungsbeispiel gleich der zweiten Hauptfläche 2 des Halbleiterchips 1 ist, auf den ersten Anschlussbereich 7 des Trägerkörpers 10 montiert. Die Montage des Halbleiterchips 1 auf den Trägerkörper 10 erfolgt beispielsweise mittels einer Lötverbindung oder einem elektrisch leitfähigen Klebstoff. An der zweiten Hauptfläche 5 weist der Halbleiterchip 1 eine zweite Kontaktfläche 6 auf, die zum Beispiel aus einer Kontaktschicht oder Kontaktschichtenfolge gebildet wird, die auf die zweite Hauptfläche 5 aufgebracht ist und zum Beispiel mittels Photolithographie strukturiert wird.

In Figur 2C ist ein Zwischenschritt dargestellt, bei dem auf den Halbleiterchip 1 und den mit den Anschlussbereichen 7, 8 versehenen Trägerkörper 10 eine Verkapselungsschicht 3 aufgebracht wird. Das Aufbringen der Verkapselungsschicht 3 erfolgt vorzugsweise durch das Aufsprühen oder Aufschleudern (Spincoating) einer Polymerlösung. Weiterhin ist auch ein Druckverfahren, insbesondere Siebdruck, zum Aufbringen der Verkapselungsschicht 3 vorteilhaft.

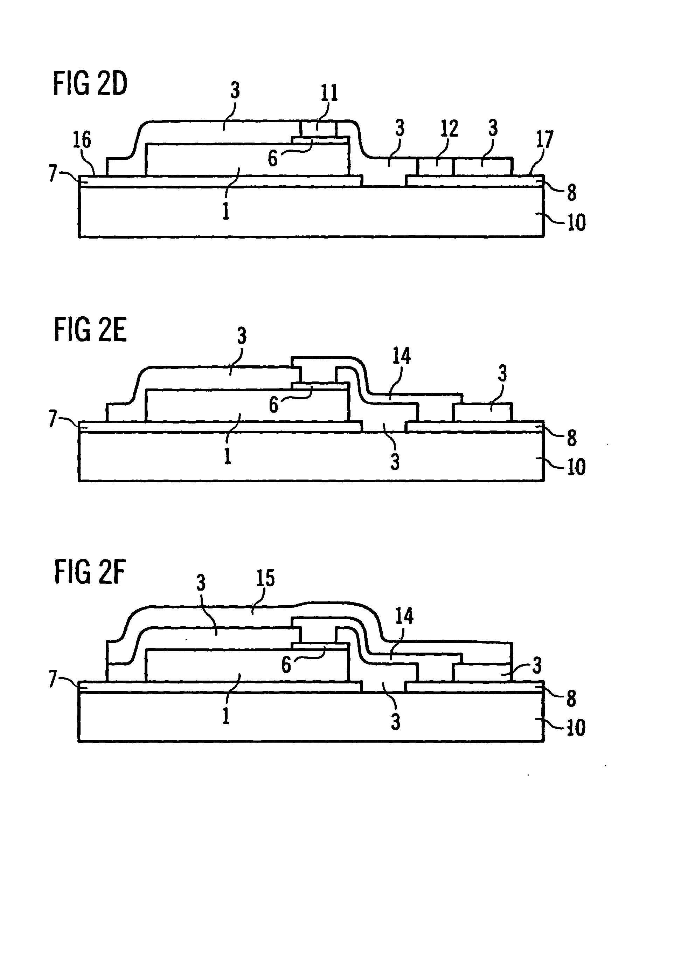

Bei dem in Figur 2D dargestellten Verfahrensschritt werden eine erste Ausnehmung 11, durch die ein Teilbereich der zweiten Kontaktfläche 6 freigelegt wird, und eine zweite Ausnehmung 12, durch die ein Teilbereich des zweiten Anschlussbereichs 8 des Trägerkörpers 10 freigelegt wird, in der Verkapselungsschicht 3 erzeugt. Die Ausnehmungen 11, 12 werden vorzugsweise mit einer Laserbearbeitung erzeugt. Vorteilhaft wird auch ein Teilbereich 16 des ersten Anschlussbereichs 7 und ein Teilbereich 17 des zweiten Anschlussbereichs 8 freigelegt, um das Anbringen elektrischer Anschlüsse an dem Trägerkörper 10 des optoelektronischen Bauelements zu ermöglichen.

Bei dem in Figur 2E dargestellten Zwischenschritt wird die zuvor durch die Ausnehmung 11 freigelegte zweite Kontaktfläche 6 durch eine elektrisch leitfähige Schicht 14 mit dem zuvor durch die Ausnehmung 12 freigelegten Bereich der zweiten Anschlussfläche 8 elektrisch leitfähig verbunden.

Die elektrisch leitfähige Schicht 14 ist zum Beispiel eine Metallschicht. Diese wird beispielsweise derart aufgebracht, dass zunächst eine vergleichsweise dünne Metallschicht, die beispielsweise etwa 100 nm dick ist, ganzflächig auf die Verkapselungsschicht 3 aufgebracht wird. Dies kann zum Beispiel durch Aufdampfen oder Sputtern erfolgen. Nachfolgend wird eine Photolackschicht (nicht dargestellt) auf die Metallschicht aufgebracht, in der mittels Phototechnik eine Ausnehmung in dem Bereich erzeugt wird, in dem die elektrisch leitfähige Schicht 14 die zweite Kontaktfläche 6 mit dem zweiten Anschlussbereich 8 verbinden soll.

In dem Bereich der Ausnehmung in der Photolackschicht wird die zuvor aufgebrachte Metallschicht durch eine galvanische Abscheidung verstärkt. Dies erfolgt vorteilhaft derart, dass die Metallschicht in dem galvanisch verstärkten Bereich wesentlich dicker ist als die zuvor ganzflächig aufgebrachte Metallschicht. Beispielsweise kann die Dicke der Metallschicht in dem galvanisch verstärkten Bereich mehrere µm betragen. Nachfolgend wird die Photolackschicht entfernt und ein Ätzprozess durchgeführt, mit dem die Metallschicht in dem nicht galvanisch verstärkten Bereich vollständig abgetragen wird. In dem galvanisch verstärkten Bereich wird die Metallschicht aufgrund ihrer größeren Dicke dagegen nur zu einem Teil abgetragen, so dass sie in diesem Bereich als elektrisch leitfähige Schicht 14 verbleibt.

Alternativ ist es auch möglich, dass die elektrisch leitfähige Schicht 14 direkt in strukturierter Form auf die Verkapselungsschicht 3 aufgebracht wird. Dies kann beispielsweise mit einem Druckverfahren, insbesondere mit einem Siebdruckverfahren, erfolgen.

Eine Strukturierung oder ein strukturiertes Aufbringen der elektrisch leitfähigen Schicht 14 ist vorteilhaft nicht erforderlich, wenn eine für die emittierte Strahlung transparente elektrisch leitfähige Schicht 14 aufgebracht wird. Als elektrisch leitfähige transparente Schicht ist insbesondere ein transparentes leitfähiges Oxid (TCO) vorzugsweise Indium-Zinn-Oxid (ITO), oder alternativ eine elektrisch leitfähige Kunststoffschicht geeignet. Die elektrisch leitfähige transparente Schicht wird vorzugsweise durch Aufdampfen, Aufdrucken, Aufsprühen oder Aufschleudern (Spincoating) aufgebracht.

Bei dem in Figur 2F dargestellten Verfahrensschritt wird eine elektrisch isolierende Deckschicht 15 aufgebracht. Die isolierende Deckschicht 15 ist vorzugsweise eine Kunststoffschicht, zum Beispiel eine Lackschicht. Die isolierende Deckschicht 15 bedeckt insbesondere die elektrisch leitfähige Schicht 14, um eine potentialfreie Oberfläche zu erzeugen.

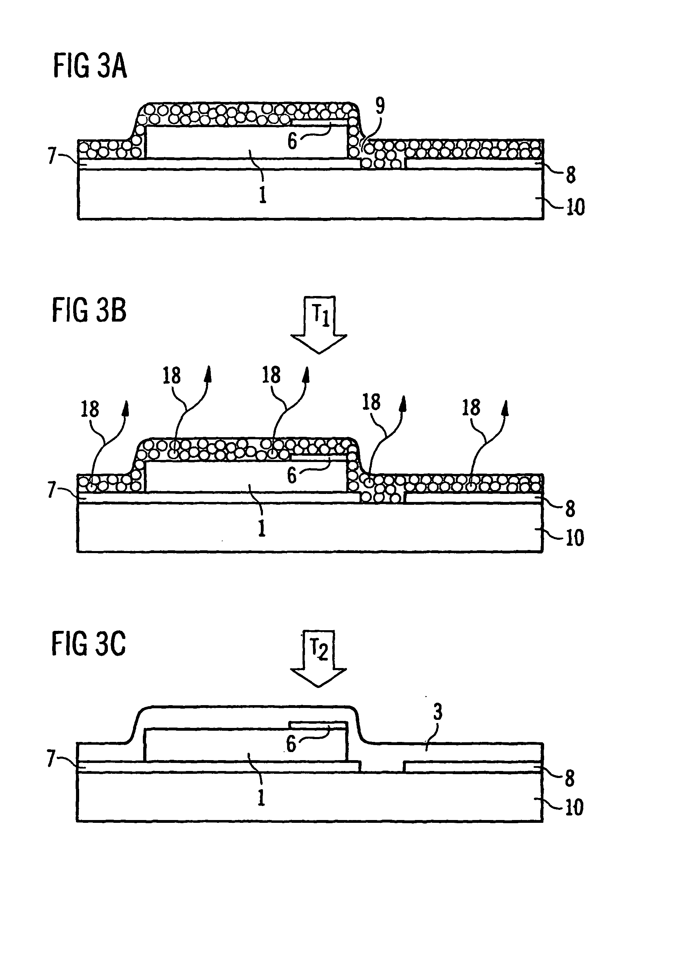

Eine alternative Variante des Aufbringens der Verkapselungsschicht 3, also des zuvor in der Figur 2C dargestellten Zwischenschritts, wird im folgenden anhand der Figuren 3A, 3B und 3C erläutert.

Dabei wird auf den Halbleiterchip 1 und den Trägerkörper 10 zunächst eine Precursor-Schicht 9 aufgebracht, die sowohl organische als auch anorganische Bestandteile enthält.

Das Aufbringen der Precursor-Schicht erfolgt beispielsweise mittels einem Sol-Gel-Verfahren, durch Aufdampfen, Sputtern, Aufsprühen oder durch Aufschleudern (Spincoating) einer Suspension.

Durch eine Temperaturbehandlung bei einer Temperatur T₁ von vorzugsweise etwa 200 °C bis 400 °C für etwa 4 h bis 8 h in einer neutralen N₂-Atmosphäre oder unter geringem O₂-Partialdruck werden die organischen Bestandteile der Precursor-Schicht 9, wie in Fig. 3B durch die Pfeile 18 angedeutet, entfernt.

Die so entstandene Schicht wird nachfolgend, wie in Fig. 3C schematisch dargestellt ist, mit einem Sinterprozess verdichtet, um die Verkapselungsschicht 3 zu erzeugen. Das Sintern erfolgt durch eine weitere Temperaturbehandlung bei einer Temperatur T₂ von vorzugsweise etwa 300°C bis 500°C für etwa 4 h bis 8 h. Abhängig von der Art der Glasschicht wird das Sintern vorzugsweise unter einer reduzierenden oder oxidierenden Atmosphäre durchgeführt.

Die in den Figuren 3A, 3B und 3C beschriebenen Verfahrensschritte können in analoger Weise auch zur Herstellung einer Deckschicht 15, die aus einem Glas besteht, verwendet werden. In diesem Fall werden diese Verfahrensschritte bevorzugt ein erstes Mal durchgeführt, um eine Verkapselungsschicht 3, die aus einem Glas besteht, zu erzeugen, und nach dem Aufbringen der elektrisch leitfähigen Schicht 14 wiederholt, um eine Deckschicht 15 aus einem Glas abzuscheiden.

Durch eine mehrfache Wiederholung des Aufbringens einer elektrisch isolierenden Schicht und einer elektrisch leitfähigen Schicht können auch mehrlagige Verschaltungen realisiert werden. Dies ist insbesondere für LED-Module, die mehrere Halbleiterchips enthalten, vorteilhaft.

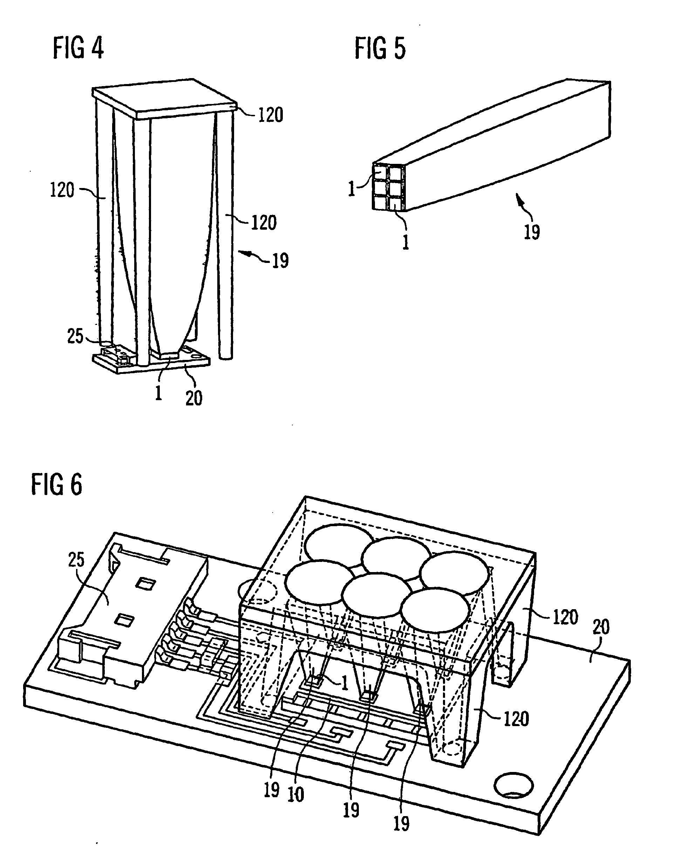

In den Figuren 4 bis 8 sind Beleuchtungseinrichtungen mit mindestens einem optoelektronischen Bauelement dargestellt, die jeweils mindestens ein optisches Element 19 aufweisen, wobei jedem Halbleiterchip 1 des optoelektronischen Bauelements ein optisches Element zugeordnet ist.

Bei dem in Figur 6 dargestellten dritten Ausführungsbeispiel der Beleuchtungseinrichtung sind über den Halbleiterchips (1) eine Mehrzahl optischer Elemente 19 angeordnet, die zum Beispiel einstückig miteinander ausgebildet sind. Das in Figur 4 dargestellte optoelektronische Bauelement weist dagegen ein einziges optisches Element auf. Dieses optische Element 19 ist CPCartig ausgebildet.

Jeder Halbleiterchip 1 des optoelektronischen Bauelements ist beispielsweise einem einzigen optischen Element 19 zugeordnet. Ein den Halbleiterchips zugewandter Strahleneingang der optischen Elemente weist eine Strahlungseingangsöffnung, deren Seiten z.B. ≤ 1,5 mal einer entsprechenden horizontalen Kantenlänge der Halbleiterchips, bevorzugt von ≤ 1,25 mal dieser Kantenlänge ist. Ordnet man einen derart kleinen Strahleneingang möglichst nah am Halbleiterchip an, kann man eine Divergenz der von den Halbleiterchips emittierten Strahlung auf effektive Weise verringern und einen Strahlenkegel mit einer hohen Leuchtdichte erzeugen.

Statt jedem Halbleiterchip ein einziges eigenes optisches Element 19 zuzuordnen, kann das optische Element 19 auch für eine Mehrzahl von Halbleiterchips 1 vorgesehen sein, wie das beispielsweise bei dem optischen Element 19 des in Figur 5 dargestellten Bauelements der Fall ist. Dieses optische Element 19 ist auch in der Art eines CPC ausgebildet. Das optische Element 19 ist beispielsweise für sechs Halbleiterchips 1 vorgesehen.

Zur Erwirkung einer möglichst hohen Effizienz sollte die Halbleiterchips 1 möglichst nah beieinander angeordnet sein. Zumindest ein Teil benachbarter Halbleiterchips 1 weisen beispielsweise einen Abstand von ≤ 50 µm zueinander auf. Besonders bevorzugt weisen diese Halbleiterchips im wesentlichen keinen Abstand zueinander auf.

Als Alternative zu einem CPC-artigen Konzentrator weist das optische Element 19 zum Beispiel Seitenwände auf, die in geraden Linien von dem Strahleneingang zum Strahlenausgang verlaufen. Ein Beispiel für derartige optische Elemente 19 ist in Figur 6 dargestellt. Bei derartigen optischen Elementen 19 ist der Strahlenausgang bevorzugt mit einer sphärischen oder asphärischen Linse versehen bzw. in der Art einer derartige Linse nach außen gewölbt.

Der Vorteil einer asphärischen Wölbung, verglichen mit einer sphärischen Wölbung, ist, dass die asphärische Wölbung beispielsweise mit zunehmendem Abstand von der optischen Achse des optischen Elements 19 abnimmt. Dadurch wird dem Umstand Rechnung getragen, dass der Strahlenkegel, dessen Divergenz durch das optische Element 19 zu verringern ist, keine punktförmige Lichtstrahlungsquelle, sondern einen Strahlungsquelle mit einer gewissen Ausdehnung ist.

Ein derartiges optisches Element mit gerade vom Strahleneingang zum Strahlenausgang verlaufenden reflektierenden Wänden hat verglichen mit einem CPC-artigen optischen Element den Vorteil, dass mit ihm eine vergleichbare Verringerung der Divergenz eines Strahlenkegels bei gleichzeitig signifikanter Verringerung der Bauhöhe des optischen Elements 19 erzielt werden kann. Ein weiterer Vorteil derartiger optischer Elemente ist, dass ihre geraden Seitenflächen einfacher mittels eines Spritzverfahrens wie beispielsweise Spritzgießen oder Spritzpressen hergestellt werden können, während die Ausbildung gewölbter Seitenflächen wie bei CPC-artigen Konzentratoren vergleichsweise schwierig ist.

Bei dem optischen Element handelt es sich bevorzugt um einen dielektrischen Konzentrator mit einem Grundkörper aus einem dielektrischen Material. Alternativ ist jedoch auch die Verwendung eines Konzentrators mit einem Grundkörper, der einen entsprechenden Hohlraum mit reflektierenden Innenwänden definiert, möglich.

Wenn das optische Element 19 in der Art eines dielektrischen Konzentrators ausgebildet ist, sind in der Regel zusätzliche Befestigungsvorrichtungen nötig, um das optische Element 19 auf oder relativ zu den Halbleiterchips zu positionieren.

Die in den Figuren 4 und 6 dargestellten optischen Elemente weisen Halteelemente 120 auf, die sich in der Nähe des Strahlenausgangs des optischen Elements bzw. der optischen Elemente 19 von dem dielektrischen Grundkörper weg erstrecken und seitlich von diesem wegragen sowie in einem Abstand zu dem Grundkörper in Richtung des Strahleneingangs verlaufen.

Die Halteelemente 120 können beispielsweise säulenartige Elemente umfassen, auf denen die optischen Elemente aufgestellt und somit relativ zu den Halbleiterchips 1 positioniert werden können.

Als Alternative zu derartigen Halteelementen 120 können die optischen Elemente 19 auch mittels separater Halterungsvorrichtungen montiert und positioniert werden. Beispielsweise können sie in einen separaten Rahmen gesteckt werden.

Die in den Figuren 4 und 6 dargestellten Bauelemente sind optoelektronische Module, die einen Modulträger 20 aufweisen. Auf oder in dem Modulträger sind elektrische Leiterbahnen und ein Gegenstecker 25 ausgebildet, über den das Modul mittels eines entsprechenden Steckers elektrisch angeschlossen werden kann.

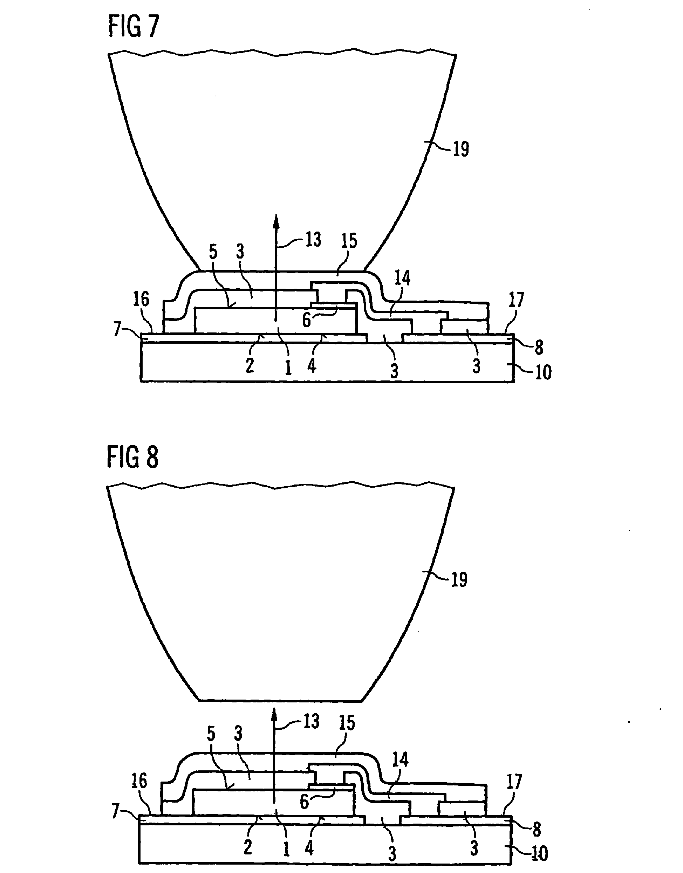

Bei dem in Figur 7 dargestellten Bauelement ist das optische Element 19 unmittelbar derart auf der isolierenden Deckschicht 15 aufgebracht, dass der Strahleneingang des optischen Elementes 19 an dieser angrenzt. Die Deckschicht 15 fungiert dabei als ein Koppelmaterial für das optische Element. Alternativ kann das Koppelmaterial auch in Form einer zusätzlichen Schicht auf dem Halbleiterchip 1 aufgebracht werden. Unter einem "Koppelmaterial" ist beispielsweise ein dielektrisches Material zu verstehen, das für die von den Halbleiterchips 1 emittierte Strahlung durchlässig ist und einen Brechungsindex aufweist, der bevorzugt demjenigen eines Halbleitermaterials der Halbleiterchips 1 entspricht, so dass Fresnel-Verluste und Totalreflexionen an Grenzflächen zwischen dem Halbleiterchip 1 und dem optischen Element 19 signifikant verringert sind.

Fresnel-Verluste sind Verluste aufgrund von Reflexionen an Grenzflächen, an denen es einen Brechungsindexsprung gibt. Ein typisches Beispiel ist der Brechungsindexsprung zwischen Luft und einem dielektrischen Material, beispielsweise beim Eintritt oder Austritt von elektromagnetischer Strahlung in ein bzw. aus einem optischen Element.

Der Halbleiterchip 1 ist also mittels des Koppelmaterials optisch an den dielektrischen Grundkörper des optischen Elements 19 angekoppelt. Das Koppelmaterial ist beispielsweise ein strahlungsdurchlässiges Gel mit einem Brechungsindex, der entweder an den Brechungsindex des dielektrischen Körpers des optischen Elements 19 oder an den Brechungsindex eines Halbleitermaterials der Halbleiterchips 1 angepasst ist oder zwischen den Brechungsindizes dieser beiden Materialien liegt. Alternativ zu einem Gel kann beispielsweise auch ein Epoxydharz oder ein lackartiges Material verwendet werden.

Der Brechungsindex des Koppelmaterials liegt bevorzugt zwischen dem des dielektrischen Körpers des optischen Elements 19 und eines Halbleitermaterials der Halbleiterchips 1. Wesentlich ist, dass der Brechungsindex signifikant größer als 1 ist. Beispielsweise wird ein Koppelmaterial für das Koppelmedium verwendet, dessen Brechungsindex größer als 1,3, bevorzugt größer als 1,4 ist. Hierfür kommen z.B. Silikone in Frage. Es sind aber auch andere Stoffe wie z.B. Flüssigkeiten als Koppelmedium möglich. Wasser hat beispielsweise einen Brechungsindex von größer als etwa 1,3 und ist als Koppelmedium grundsätzlich geeignet.

Bei dem in Figur 8 dargestellten Ausführungsbeispiel besteht zwischen dem Halbleiterchip 1 und dem optischen Element 19 ein Spalt 5, beispielsweise ein Luftspalt. Alternativ kann der Spalt 5 auch mit einem anderen Gas gefüllt sein und es ist ebenso möglich, dass in dem Spalt 5 ein Vakuum herrscht. Der Spalt bewirkt, dass ein hochdivergenter Anteil der vom Halbleiterchip 1 emittierten Strahlung aufgrund von Reflexionen an den Grenzflächen in geringerem Maße in das optische Element 19 einkoppelt als ein niederdivergenter Anteil. Dies kann für die Erzeugung von in hohem Maße kollimierten Strahlenkegeln sowie bei Anwendungen vorteilhaft sein, bei denen ein hochdivergenter Anteil stören könnte. Ein Beispiel hierfür sind Projektionsanwendungen.

Bei dem in Figur 7 dargestellten Ausführungsbeispiel beträgt der Abstand des Strahleneingangs des optischen Elements zu dem Halbleiterchip 1 weniger als 100 µm z.B. nur etwa 60 µm. Bei dem in Figur 8 dargestellten Ausführungsbeispiel beträgt der Abstand des Strahleneingangs des optischen Elements zu dem Halbleiterchip z.B. 180 µm.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronisches Bauelement, das Strahlung in eine Hauptstrahlungsrichtung (13) emittiert, mit einem Halbleiterchip (1), der eine erste Hauptfläche (2), eine erste Kontaktfläche (4), und eine der ersten Hauptfläche (2) gegenüberliegende zweite Hauptfläche (5) mit einer zweiten Kontaktfläche (6) aufweist, sowie mit einem Trägerkörper (10), der zwei voneinander isolierte elektrische Anschlussbereiche (7, 8) aufweist, wobei der Halbleiterchip (1) mit der ersten Hauptfläche (2) auf dem Trägerkörper (10) befestigt ist und die erste Kontaktfläche (4) mit dem ersten Anschlussbereich (7) elektrisch leitend verbunden ist,
wobei
- der Halbleiterchip (1) und der Trägerkörper (10) mit einer transparenten, elektrisch isolierenden Verkapselungsschicht (3) versehen sind,
- die in der Hauptstrahlungsrichtung (13) emittierte Strahlung durch die Verkapselungsschicht (3) ausgekoppelt wird, und
- eine elektrisch leitfähige Schicht (14) von der zweiten Kontaktfläche (6) über einen Teilbereich der Verkapselungsschicht (3) zu dem zweiten elektrischen Anschlussbereich (8) des Trägerkörpers (10) geführt ist, welche die zweite Kontaktfläche (6) mit dem zweiten Anschlussbereich (8) elektrisch leitend verbindet.

2. Optoelektronisches Bauelement nach Anspruch 1,
**dadurch gekennzeichnet, dass**
die Verkapselungsschicht (3) ein Lumineszenz-Konversionsmaterial enthält.

3. Optoelektronisches Bauelement nach Anspruch 1 oder 2,
**dadurch gekennzeichnet, dass**
die Verkapselungsschicht (3) eine Kunststoffschicht ist.

4. Optoelektronisches Bauelement nach Anspruch 3,
**dadurch gekennzeichnet, dass**
die Verkapselungsschicht (3) Silikon enthält.

5. Optoelektronisches Bauelement nach Anspruch 1 oder 2,
**dadurch gekennzeichnet, dass**
die Verkapselungsschicht (3) eine Glasschicht ist.

6. Optoelektronisches Bauelement nach einem der vorhergehenden Ansprüche,
**dadurch gekennzeichnet, dass**
die erste Kontaktfläche (4) an der ersten Hauptfläche (2) des Halbleiterchips angeordnet ist, wobei der Halbleiterchip (1) mit der ersten Kontaktfläche (4) mittels einer elektrisch leitfähigen Verbindung auf dem ersten Anschlussbereich (7) montiert ist.

7. Optoelektronisches Bauelement nach einem der Ansprüche 1 bis 5,
**dadurch gekennzeichnet, dass**
die erste Kontaktfläche an der zweiten Hauptfläche (5) des Halbleiterchips (1) angeordnet ist, und eine weitere elektrisch leitfähige Schicht von der ersten Kontaktfläche über einen Teilbereich der Verkapselungsschicht (3) zu dem ersten elektrischen Anschlussbereich (7) des Trägerkörpers (10) geführt ist, welche die erste Kontaktfläche mit dem ersten Anschlussbereich (7) elektrisch leitend verbindet.

8. Optoelektronisches Bauelement nach einem der vorhergehenden Ansprüche,
**dadurch gekennzeichnet, dass**
die elektrisch leitfähige Schicht (14) eine für die emittierte Strahlung transparente Schicht ist.

9. Optoelektronisches Bauelement nach Anspruch 8,
**dadurch gekennzeichnet, dass**
die elektrisch leitfähige Schicht (14) ein transparentes leitfähiges Oxid, vorzugsweise Indium-Zinn-Oxid, enthält.

10. Optoelektronisches Bauelement nach einem der Ansprüche 1 bis 7,
**dadurch gekennzeichnet, dass**
die elektrisch leitfähige Schicht (14) eine strukturierte Metallschicht ist.

11. Optoelektronisches Bauelement nach einem der vorhergehenden Ansprüche,
**dadurch gekennzeichnet, dass**
eine isolierende Deckschicht (15) auf die elektrisch leitfähige Schicht (14) aufgebracht ist.

12. Optoelektronisches Bauelement nach Anspruch 11,
**dadurch gekennzeichnet, dass**
die Deckschicht (15) eine Glasschicht ist.

13. Verfahren zur Herstellung eines optoelektronischen Bauelements, das Strahlung in eine Hauptstrahlungsrichtung (13) emittiert, mit einem Halbleiterchip (1), der eine erste Hauptfläche (2), eine erste Kontaktfläche (4) und eine der ersten Hauptfläche (2) gegenüberliegende zweite Hauptfläche (5) mit einer zweiten Kontaktfläche (6) aufweist, sowie mit einem Trägerkörper (10), der zwei elektrisch voneinander isolierte Anschlussbereiche (7, 8) aufweist,
wobei das Verfahren die folgenden Verfahrensschritte aufweist
- Montage des Halbleiterchips (1) mit der ersten Hauptfläche (2) auf den Trägerkörper (10),
- Aufbringen einer transparenten elektrisch isolierenden Verkapselungsschicht (3) auf den Halbleiterchip (1) und den Trägerkörper (10),
- Erzeugung einer ersten Ausnehmung (11) in der Verkapselungsschicht (3) zur zumindest teilweisen Freilegung der zweiten Kontaktfläche (6) des Halbleiterchips (1) und einer zweiten Ausnehmung (12) in der Verkapselungsschicht (3) zur zumindest teilweisen Freilegung des zweiten Anschlussbereichs (8) des Trägerkörpers (10),
- Aufbringen einer elektrisch leitfähigen Schicht (14), die die zweite Kontaktfläche (6) des Halbleiterchips und den zweiten Anschlussbereich (8) des Trägerkörpers (10) elektrisch leitend verbindet.

14. Verfahren nach Anspruch 13,
**dadurch gekennzeichnet, dass**
die Verkapselungsschicht (3) eine Kunststoffschicht ist.

15. Verfahren nach Anspruch 13 oder 14,
**dadurch gekennzeichnet, dass**
die Verkapselungsschicht (3) durch Auflaminieren einer Folie, Aufdrucken, Aufsprühen oder Aufschleudern aufgebracht wird.

16. Verfahren nach Anspruch 13,
**dadurch gekennzeichnet, dass**
die Verkapselungsschicht (3) eine Glasschicht ist.

17. verfahren nach Anspruch 16,
**dadurch gekennzeichnet, dass**
das Aufbringen der Verkapselungsschicht (3) die Verfahrenschritte umfasst:
- Aufbringen einer Precursorschicht (9), die anorgansiche und organische Bestandteile enthält,
- eine erste Temperaturbehandlung zur Entfernung der organischen Bestandteile aus der Precursorschicht (9),
- eine zweite Temperaturbehandlung, um die Precursorschicht (9) in eine Glasschicht (3) zu verdichten.

18. Verfahren nach einem der Ansprüche 13 bis 17,
**dadurch gekennzeichnet, dass**
die erste Ausnehmung (11) und die zweite Ausnehmung (12) in der Verkapselungsschicht (3) durch eine Laserbearbeitung erzeugt werden.

19. Verfahren nach einem der Ansprüche 13 bis 18,
**dadurch gekennzeichnet, dass**
zur Herstellung der elektrisch leitfähigen Schicht (14) eine Metallschicht mit einem PVD-Verfahren aufgebracht und nachfolgend mittels galvanischer Abscheidung verstärkt wird.

20. Verfahren nach einem der Ansprüche 13 bis 18,
**dadurch gekennzeichnet, dass**
die elektrisch leitfähige Schicht (14) mit einem Druckverfahren aufgebracht wird.

21. Verfahren nach einem der Ansprüche 13 bis 18,
**dadurch gekennzeichnet, dass**
die elektrisch leitfähige Schicht (14) durch Aufsprühen oder Aufschleudern aufgebracht wird.

22. Verfahren nach einem der Ansprüche 13 bis 21,
**dadurch gekennzeichnet, dass**
eine elektrisch isolierende Deckschicht (15) auf die elektrisch leitfähige Schicht (14) aufgebracht wird.

23. Verfahren nach Anspruch 22,
**dadurch gekennzeichnet, dass**
die Deckschicht (15) eine Glasschicht ist.

24. Verfahren nach Anspruch 23,
**dadurch gekennzeichnet, dass**
das Aufbringen der Deckschicht (15) die Verfahrenschritte umfasst:
- Aufbringen einer Precursorschicht (9), die anorganische und organische Bestandteile enthält,
- eine erste Temperaturbehandlung zur Entfernung der organischen Bestandteile aus der Precursorschicht (9),
- eine zweite Temperaturbehandlung, um die Precursorschicht (15) in eine Glasschicht zu verdichten.

25. Beleuchtungseinrichtung, die ein optoelektronisches Bauelement gemäß einem der Ansprüche 1 bis 12 enthält.

26. Beleuchtungseinrichtung nach Anspruch 25,
**dadurch gekennzeichnet, dass**
die Beleuchtungseinrichtung ein Scheinwerfer ist.

27. Beleuchtungseinrichtung nach Anspruch 26,
**dadurch gekennzeichnet, dass**
der Scheinwerfer ein Frontscheinwerfer eines Kraftfahrzeugs ist.

28. Beleuchtungseinrichtung nach einem der Ansprüche 25 bis 27,
**dadurch gekennzeichnet, dass** mindestens ein optisches Element enthalten ist, das in der Art eines nichtabbildenden optischen Konzentrators ausgebildet ist, der, verglichen mit einer üblichen Verwendung eines Konzentrators, für eine Durchstrahlung in umgekehrter Richtung vorgesehen ist.

29. Beleuchtungseinrichtung nach einem der Ansprüche 25 bis 28, **dadurch gekennzeichnet, dass** eine Mehrzahl von Halbleiterchips enthalten ist und ein Teil benachbarter Halbleiterchips oder alle benachbarten Halbleiterchips zueinander einen Abstand von kleiner als oder gleich 300 µm und größer als oder gleich 0 µm aufweisen.

30. Beleuchtungseinrichtung nach Anspruch 29, **dadurch gekennzeichnet, dass** ein Teil benachbarter Halbleiterchips oder alle benachbarten Halbleiterchips einen Abstand von kleiner als oder gleich 100 µm und größer als oder gleich 0 µm aufweisen.

31. Beleuchtungseinrichtung nach einem der Ansprüche 28 bis 30, **dadurch gekennzeichnet, dass** ein Strahleneingang des optischen Elements zu den ihm zugeordneten Halbleiterchips einen Abstand von kleiner als oder gleich 300 µm, bevorzugt von kleiner als oder gleich 200 µm und größer als 0 µm aufweist.

## Claims

1. Optoelectronic component which emits radiation in a main radiation direction (13), comprising a semiconductor chip (1) having a first main area (2), a first contact area (4), and a second main area (5) opposite the first main area (2) with a second contact area (6), and also comprising a carrier body (10) having two electrical connection regions (7, 8) insulated from one another, the semiconductor chip (1) being fixed by the first main area (2) on the carrier body (10) and the first contact area (4) being electrically conductively connected to the first connection region (7),
wherein
- the semiconductor chip (1) and the carrier body (10) are provided with a transparent, electrically insulating encapsulation layer (3),
- the radiation emitted in the main radiation direction (13) is coupled out through the encapsulation layer (3), and
- an electrically conductive layer (14) is led from the second contact area (6) over a partial region of the encapsulation layer (3) to the second electrical connection region (8) of the carrier body (10), and electrically conductively connects the second contact area (6) to the second connection region (8).

2. Optoelectronic component according to Claim 1,
**characterized in that**
the encapsulation layer (3) contains a luminescence conversion material.

3. Optoelectronic component according to Claim 1 or 2,
**characterized in that**
the encapsulation layer (3) is a plastic layer.

4. Optoelectronic component according to Claim 3,
**characterized in that**
the encapsulation layer (3) contains silicone.

5. Optoelectronic component according to Claim 1 or 2,
**characterized in that**
the encapsulation layer (3) is a glass layer.

6. Optoelectronic component according to one of the preceding claims,
**characterized in that**
the first contact area (4) is arranged at the first main area (2) of the semiconductor chip, the semiconductor chip (1) being mounted by the first contact area (4) on the first connection region (7) by means of an electrically conductive connection.

7. Optoelectronic component according to one of Claims 1 to 5,
**characterized in that**
the first contact area is arranged at the second main area (5) of the semiconductor chip (1), and a further electrically conductive layer is led from the first contact area over a partial region of the encapsulation layer (3) to the first electrical connection region (7) of the carrier body (10), and electrically conductively connects the first contact area to the first connection region (7).

8. Optoelectronic component according to one and the preceding claims,
**characterized in that**
the electrically conductive layer (14) is a layer that is transparent to the emitted radiation.

9. Optoelectronic component according to Claim 8,
**characterized in that**
the electrically conductive layer (14) contains a transparent conductive oxide, preferably indium tin oxide.

10. Optoelectronic component according to one of Claims 1 to 7,
**characterized in that**
the electrically conductive layer (14) is a patterned metal layer.

11. Optoelectronic component according to one of the preceding claims,
**characterized in that**
an insulating cover layer (15) is applied to the electrically conductive layer (14).

12. Optoelectronic component according to Claim 11,
**characterized in that**
the cover layer (15) is a glass layer.

13. Method for producing an optoelectronic component which emits radiation in a main radiation direction (13), comprising a semiconductor chip (1) having a first main area (2), a first contact area (4) and a second main area (5) opposite the first main area (2) with a second contact area (6), and also comprising a carrier body (10) having two connection regions (7, 8) electrically insulated from one another, wherein the method has the following method steps
- mounting the semiconductor chip (1) by the first main area (2) onto the carrier body (10),
- applying a transparent electrically insulating encapsulation layer (3) to the semiconductor chip (1) and the carrier body (10),
- producing a first cutout (11) in the encapsulation layer (3) for at least partly uncovering the second contact area (6) of the semiconductor chip (1) and a second cutout (12) in the encapsulation layer (3) for at least partly uncovering the second connection region (8) of the carrier body (10),
- applying an electrically conductive layer (14), which electrically conductively connects the second contact area (6) of the semiconductor chip and the second connection region (8) of the carrier body (10).

14. Method according to Claim 13,
**characterized in that**
the encapsulation layer (3) is a plastic layer.

15. Method according to Claim 13 or 14,
**characterized in that**
the encapsulation layer (3) is applied by laminating on a film, printing on, spraying on or spin-coating.

16. Method according to Claim 13,
**characterized in that**
the encapsulation layer (3) is a glass layer.

17. Method according to Claim 16,
**characterized in that**
the application of the encapsulation layer (3) comprises the method steps of:
- applying a precursor layer (9) containing inorganic and organic constituents,
- a first thermal treatment for removing the organic constituents from the precursor layer (9),
- a second thermal treatment in order to densify the precursor layer (9) into a glass layer (3).

18. Method according to one of Claims 13 to 17,
**characterized in that**
the first cutout (11) and the second cutout (12) are produced in the encapsulation layer (3) by means of laser machining.

19. Method according to one of Claims 13 to 18,
**characterized in that**
in order to produce the electrically conductive layer (14), a metal layer is applied by a PVD method and is subsequently reinforced by means of electrodeposition.

20. Method according to one of Claims 13 to 18,
**characterized in that**
the electrically conductive layer (14) is applied by a printing method.

21. Method according to one of Claims 13 to 18,
**characterized in that**
the electrically conductive layer (14) is applied by spraying on or spin-coating.

22. Method according to one of Claims 13 to 21,
**characterized in that**
an electrically insulating cover layer (15) is applied to the electrically conductive layer (14).

23. Method according to Claim 22,
**characterized in that**
the cover layer (15) is a glass layer.

24. Method according to Claim 23,
**characterized in that**
the application of the cover layer (15) comprises the method steps of:
- applying a precursor layer (9) containing inorganic and organic constituents,
- a first thermal treatment for removing the organic constituents from the precursor layer (9),
- a second thermal treatment in order to densify the precursor layer (9) into a glass layer.

25. Illumination device containing an optoelectronic component according to one of Claims 1 to 12.

26. Illumination device according to Claim 25,
**characterized in that**
the illumination device is a headlight.

27. Illumination device according to Claim 26,
**characterized in that**
the headlight is a front headlight of a motor vehicle.

28. Illumination device according to one of Claims 25 to 27,
**characterized in that**
at least one optical element is included which is formed in the manner of a non-imaging optical concentrator which, compared with a customary use of a concentrator, is provided for radiation transmission in the opposite direction.

29. Illumination device according to one of Claims 25 to 28,
**characterized in that**
a plurality of semiconductor chips are included and a portion of adjacent semiconductor chips or all adjacent semiconductor chips are at a distance from one another of less than or equal to 300 µm and greater than or equal to 0 µm.

30. Illumination device according to Claim 29, **characterized in that**
a portion of adjacent semiconductor chips or all adjacent semiconductor chips are at a distance of less than or equal to 100 µm and greater than or equal to 0 µm.

31. Illumination device according to one of Claims 28 to 30,
**characterized in that**
a beam entrance of the optical element is at a distance of less than or equal to 300 µm, preferably of less than or equal to 200 µm and greater than 0 µm, from the semiconductor chips assigned to it.

## Revendications

1. Composant optoélectronique émettant du rayonnement dans une direction de rayonnement principale (13), avec une puce semi-conductrice (1) comportant une première surface principale (2), une première surface de contact (4) et une deuxième surface principale (5) située à l'opposé de la première surface principale (2) avec une deuxième surface de contact (6), ainsi qu'avec un support (10) comportant deux zones de raccordement électrique (7, 8) isolées l'une de l'autre, la puce semi-conductrice (1) étant fixée avec la première surface principale (2) sur le support (10) et la première surface de contact (4) étant reliée électriquement à la première zone de raccordement électrique (7), dans lequel
- la puce semi-conductrice (1) et le support (10) étant pourvus d'une couche d'encapsulation (3) transparente, électriquement isolante,
- le rayonnement émis dans la direction de rayonnement principale (13) sortant à travers la couche d'encapsulation (3), et
- une couche électriquement conductrice (14) étant acheminée à partir de la deuxième surface de contact (6), au-dessus d'une zone partielle de la couche d'encapsulation (3) jusqu'à la deuxième zone de raccordement électrique (8) du support (10), reliant électriquement la deuxième surface de contact (6) à la deuxième zone de raccordement (8).

2. Composant optoélectronique selon la revendication 1, **caractérisé en ce que** la couche d'encapsulation (3) contient un matériau de conversion luminescent.

3. Composant optoélectronique selon la revendication 1 ou 2, **caractérisé en ce que** la couche d'encapsulation (3) est une couche de matière plastique.

4. Composant optoélectronique selon la revendication 3, **caractérisé en ce que** la couche d'encapsulation (3) contient du silicone.

5. Composant optoélectronique selon la revendication 1 ou 2, **caractérisé en ce que** la couche d'encapsulation (3) est une couche de verre.

6. Composant optoélectronique selon une des revendications précédentes, **caractérisé en ce que** la première surface de contact (4) est disposée sur la première surface principale (2) de la puce semi-conductrice, la puce semi-conductrice (1) avec la première surface de contact (4) étant montée au moyen d'une liaison électriquement conductrice sur la première zone de raccordement (7).

7. Composant optoélectronique selon une des revendications 1 à 5, **caractérisé en ce que** la première surface de contact est disposée sur la deuxième surface principale (5) de la puce semi-conductrice (1), et qu'une autre couche électriquement conductrice est acheminée à partir de la première surface de contact, au-dessus d'une zone partielle de la couche d'encapsulation (3), jusqu'à la première zone de raccordement électrique (7) du support (10), reliant électriquement la première surface de contact à la première zone de raccordement (7).

8. Composant optoélectronique selon une des revendications précédentes, **caractérisé en ce que** la couche électriquement conductrice (14) est une couche transparente pour le rayonnement émis.

9. Composant optoélectronique selon la revendication 8, **caractérisé en ce que** la couche électriquement conductrice (14) contient un oxyde transparent conducteur, de préférence de l'oxyde d'indium-étain.

10. Composant optoélectronique selon une des revendications 1 à 7, **caractérisé en ce que** la couche électriquement conductrice (14) est une couche métallique structurée.

11. Composant optoélectronique selon une des revendications précédentes, **caractérisé en ce qu'**une couche de revêtement isolante (15) est appliquée sur la couche électriquement conductrice (14).

12. Composant optoélectronique selon la revendication 11, **caractérisé en ce que** la couche de revêtement (15) est une couche de verre.

13. Procédé pour la fabrication d'un composant optoélectronique émettant du rayonnement dans une direction de rayonnement principale (13), avec une puce semi-conductrice (1) comportant une première surface principale (2), une première surface de contact (4) et une deuxième surface principale (5) située à l'opposé de la première surface principale (2) avec une deuxième surface de contact (6), ainsi qu'avec un support (10) comportant deux zones de raccordement (7, 8) électriquement isolées l'une de l'autre, le procédé comportant les étapes suivantes du procédé :
- montage de la puce semi-conductrice (1) avec la première surface principale (2) sur le support (10),
- application d'une couche d'encapsulation (3) transparente, électriquement isolante, sur la puce semi-conductrice (1) et le support (10),
- fabrication d'un premier évidement (11) dans la couche d'encapsulation (3) pour mettre à nu au moins partiellement la deuxième surface de contact (6) de la puce semi-conductrice (1) et d'un deuxième évidement (12) dans la couche d'encapsulation (3) pour mettre à nu au moins partiellement la deuxième zone de raccordement (8) du support (10),
- application d'une couche électriquement conductrice (14) reliant électriquement la deuxième surface de contact (6) de la puce semi-conductrice à la deuxième zone de raccordement électrique (8) du support (10).

14. Procédé selon la revendication 13, **caractérisé en ce que** la couche d'encapsulation (3) est une couche de matière plastique.

15. Procédé selon la revendication 13 ou 14, **caractérisé en ce que** la couche d'encapsulation (3) est appliquée par laminage d'une feuille, par pression, par pulvérisation ou par projection.

16. Procédé selon la revendication 13, **caractérisé en ce que** la couche d'encapsulation (3) est une couche de verre.

17. Procédé selon la revendication 16, **caractérisé en ce que** l'application de la couche d'encapsulation (3) comporte les étapes du procédé :
- application d'une couche précurseur (9) contenant des composants anorganiques et organiques,
- un premier traitement thermique pour éliminer les composants organiques de la couche précurseur (9),
- un deuxième traitement thermique pour condenser la couche précurseur (9) en une couche de verre.

18. Procédé selon une des revendications 13 à 17, **caractérisé en ce que** le premier évidement (11) et le deuxième évidement (12) dans la couche d'encapsulation (3) sont réalisés par un usinage laser.

19. Procédé selon une des revendications 13 à 18, **caractérisé en ce que** pour la fabrication de la couche électriquement conductrice (14) on applique une couche métallique (14) par un procédé PVD et qu'on la consolide ensuite au moyen d'un dépôt galvanique.

20. Procédé selon une des revendications 13 à 18, **caractérisé en ce que** la couche électriquement conductrice (14) est appliquée par un procédé d'impression.

21. Procédé selon une des revendications 13 à 18, **caractérisé en ce que** la couche électriquement conductrice (14) est appliquée par pulvérisation ou par projection.

22. Procédé selon une des revendications 13 à 21, **caractérisé en ce qu'**une couche de revêtement électriquement isolante (15) est appliquée sur la couche électriquement conductrice (14).

23. Procédé selon la revendication 22, **caractérisé en ce que** la couche de revêtement (15) est une couche de verre.

24. Procédé selon la revendication 23, **caractérisé en ce que** l'application de la couche de revêtement (15) comporte les étapes du procédé :
- application d'une couche précurseur (9) contenant des composants anorganiques et organiques,
- un premier traitement thermique pour éliminer les composants organiques de la couche précurseur (9),
- un deuxième traitement thermique pour condenser la couche précurseur (9) en une couche de verre.

25. Dispositif d'éclairage contenant un composant optoélectronique selon une des revendications 1 à 12.

26. Dispositif d'éclairage selon la revendication 25, **caractérisé en ce que** le dispositif d'éclairage est un phare.

27. Dispositif d'éclairage selon la revendication 26,
**caractérisé en ce que** le phare est un phare avant d'un véhicule.

28. Dispositif d'éclairage selon une des revendications 25 à 27, **caractérisé en ce qu'**il contient au moins un élément optique réalisé sous la forme d'un concentrateur optique n'assurant pas la reproduction, qui est prévu pour une transmission du rayonnement en direction opposée à celle d'une utilisation habituelle d'un concentrateur.

29. Dispositif d'éclairage selon une des revendications 25 à 28, **caractérisé en ce qu'**il contient une pluralité de puces semi-conductrices et qu'une partie des puces semi-conductrices voisines ou toutes les puces semi-conductrices voisines présentent un espacement inférieur ou égal à 300 µm et supérieur ou égal à 0 µm.

30. Dispositif d'éclairage selon la revendication 29, **caractérisé en ce qu'**une partie des puces semi-conductrices voisines ou toutes les puces semi-conductrices voisines présentent un espacement inférieur ou égal à 100 µm et supérieur ou égal à 0 µm.

31. Dispositif d'éclairage selon une des revendications 28 à 30, **caractérisé en ce qu'**une entrée du faisceau de l'élément optique vers les puces semi-conductrices qui lui correspondent présente un espacement inférieur ou égal à 300 µm, de préférence inférieur ou égal à 200 µm et supérieur à 0 µm.
